(19) Europäisches Patentamt
European Patent Office
Office européen des brevets

(11) **EP 2 983 221 B1**

(12) **EUROPEAN PATENT SPECIFICATION**

(45) Date of publication and mention
of the grant of the patent:
**07.10.2020   Bulletin 2020/41**

(51) Int Cl.:
***H01L 51/50*** *(2006.01)*

(21) Application number: **14180200.9**

(22) Date of filing: **07.08.2014**

(54) **Light emitting device**

Lichtemittierende Vorrichtung

Dispositif électroluminescent

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.02.2016   Bulletin 2016/06**

(73) Proprietor: **OLEDWorks GmbH
52068 Aachen (DE)**

(72) Inventors:
• **GOLDMANN, Claudia Michaela
52399 Merzenich (DE)**

• **LÖBL, Hans-Peter
52156 Monschau (DE)**

(74) Representative: **Gunzelmann, Rainer
Wuesthoff & Wuesthoff
Patentanwälte PartG mbB
Schweigerstraße 2
81541 München (DE)**

(56) References cited:
**WO-A2-2012/162203      US-A1- 2010 288 362
US-A1- 2012 205 685      US-A1- 2012 241 726
US-A1- 2014 061 600**

**Description**

FIELD OF THE INVENTION

The invention relates to a red light emitting device and a vehicle comprising the red light emitting device. The invention relates further to a manufacturing method for manufacturing the light emitting device.

BACKGROUND OF THE INVENTION

Automotive lightings generally need to provide light within certain predefined wavelength ranges. For instance, automotive rear red lights generally need to have a deep red light emission with wavelengths within a range of, for example, 620 to 630 nm. Light emitting devices comprising organic light emitting diodes typically have a broad visible emission spectrum. Thus, even if the light emitting devices comprising organic light emitting diodes emit within the red part of the spectrum, the effective color points of these light emitting devices as perceived by human eyes will be shifted towards the yellow part of the visible spectrum, because the spectral sensitivity of human eyes is higher for wavelengths that are closer to or within the yellow part of the visible spectrum than for wavelengths that are closer to or within the red part of the spectrum. Light emitting devices, which are based on organic light emitting diodes, are therefore often not very suitable for certain automotive applications like automotive rear light applications.

US 2012/205685 A1 discloses a light-emitting element with which a reduction in power consumption and an improvement in productivity of a display device can be achieved is provided. A technique of manufacturing a display device with high productivity is provided. The light-emitting element includes an electrode having a reflective property, and a first light-emitting layer, a charge generation layer, a second light-emitting layer, and an electrode having a light-transmitting property stacked in this order over the electrode having a reflective property. The optical path length between the electrode having a reflective property and the first light-emitting layer is one-quarter of the peak wavelength of the emission spectrum of the first light-emitting layer. The optical path length between the electrode having a reflective property and the second light-emitting layer is three-quarters of the peak wavelength of the emission spectrum of the second light-emitting layer.

US 2010/288362 A1 discloses an electronic device, e.g. a tandem OLED, including an anode and a cathode, between which there are at least two organic phototransducing units where the units are separated by an intermediate connecting region which comprises in sequence: an organic p-type layer, an intermediate layer in direct contact with the organic p-type layer and including a compound that has a LUMO more negative than -3.0 eV and is different from the organic compound in the organic p-type layer, and an n-type doped organic layer in direct contact with the intermediate layer and including an electron transport material as a host and an organic n-dopant with a HOMO less negative than -4.5 eV.

US 2014/061600 A1 discloses a pyrene compound and an organic light emitting diode device including the same. The organic light emitting diode device includes at least two stacks provided between a first electrode and a second electrode, and a charge generation layer provided between the stacks and including an N type charge generation layer and a P type charge generation layer, wherein the N type charge generation layer is made of the pyrene compound

US 2012/241726 A1 discloses an OLED device comprising a red emitting layer and charge generation layers.

WO 2012/162203 A2 discloses a rear light of a vehicle.

SUMMARY OF THE INVENTION

It is an object of a present invention to provide a red light emitting device comprising an organic light emitting diode, which is more suitable for automotive applications. It is a further object of the present invention to provide a vehicle comprising the light emitting device and a manufacturing method for manufacturing the light emitting device.

In a first aspect of the present invention a light emitting device for emitting light is presented, wherein the light emitting device comprises the features of claim 1. Since the light emitting device comprises a stack including a first electrode, an organic light emitting diode, a charge generation unit and a second electrode, wherein the organic light emitting diode and the charge generation unit are arranged in between the first and second electrodes and wherein the charge generation unit comprises an absorbing layer having an absorption shifting the light emitted by the light emitting device towards a longer wavelength within the red part of the spectrum, the light emitting device is better usable in automotive applications. For instance, the light emitting device can be used in a rear light of a vehicle.

The absorbing layer is preferentially adapted such that it has an absorption shifting the spectral centroid of the emission of the light emitting device towards a longer wavelength within the red part of the visible spectrum, wherein the red part of the spectrum may be defined by a wavelength range of 620 to 740 nm. The spectral centroid is preferentially defined as the weighted mean of the emission spectrum, wherein the weights correspond to the intensity values at the respective wavelengths. Already without the absorbing layer the spectral centroid of the emitted light might be within the red part of the spectrum, wherein due to the absorbing layer the spectral centroid may be shifted to a longer wavelength within the red part.

The stack preferentially comprises a further organic light emitting diode, wherein the charge generation unit may be arranged between the organic light emitting diodes. This can lead to an increased red light intensity.

The charge generation unit comprises a diffusion barrier layer for reducing diffusion within the charge generation unit. The diffusion barrier layer is the absorbing layer. The diffusion barrier layer may comprise, for instance, rubrene and/or pentacene. The diffusion barrier layer can reduce, especially eliminate, a diffusion of atoms and/or molecules into an organic light emitting diode, thereby reducing the likelihood of degrading the organic light emitting diode due to the diffused atoms and/or molecules. This can increase the temperature stability of the light emitting device. In particular, it can reduce, especially eliminate, a drive voltage increase versus operation and/or storage time, which may be present in known light emitting devices comprising organic light emitting diodes at higher temperatures being larger than, for instance, 50 degrees Celsius. This temperature stability can further improve the usability of the light emitting device in automotive applications. The charge generation unit comprises a p-doped layer and an n-doped layer according to the claims.

The absorbing layer may comprise organic material and/or inorganic material and/or metal organic material, especially may consist of organic material and/or inorganic material and/or metal organic material. The organic absorbing material may be a material selected from a group consisting of pentacene, pentacene derivatives, rubrene and rubrene derivatives. Moreover, the organic absorbing material may be a polymer like, for instance, Poly(3-hexylthiophen-2,5-diyl) (P3HT). The inorganic absorbing material may be metal like copper and/or gold, in particular, copper and/or gold nanoparticles, and the metal organic material may be metal complexes. Thus, for instance, a p-doped layer and/or an n-doped layer and/or a diffusion barrier layer and/or an additional other layer of the charge generation unit can comprise absorbing materials for shifting the light emitted by the light emitting device towards a longer wavelength within the red part of the spectrum, wherein these absorbing materials may include, for instance, pentacene and/or pentacene derivatives and/or rubrene and/or rubrene derivatives and/or metal particles and/or other organic, inorganic or metal organic materials shifting the light emitted by the light emitting device towards a longer wavelength within the red part of the spectrum.

In an embodiment the charge generation unit is arranged between one of the electrodes and the organic light emitting diode. For instance, in an embodiment the light emitting device does not comprise a stack of at least two organic light emitting diodes with an intermediate charge generation unit, but the light emitting device may comprise a single organic light emitting diode between the first and second electrodes, wherein the charge generation unit may be arranged in between one of the first and second electrodes and the single organic light emitting diode. In a further embodiment the light emitting device may comprise at least two organic light emitting diodes arranged in a stack in between the first and second electrodes, wherein in between the organic light emitting diodes and also in between an organic light emitting diode and an electrode a charge generation unit is arranged. At least one of these charge generation units comprises the absorbing layer having the absorption shifting the light emitted by the light emitting device towards a longer wavelength within the red part of the spectrum.

In a further aspect of the present invention a vehicle is presented, wherein the vehicle comprises a light emitting device as defined in claim 1. For instance, the vehicle can comprise a rear light having included the light emitting device as defined in claim 1.

In a further aspect of the present invention a manufacturing method for manufacturing a light emitting device as defined in claim 1 is presented, wherein the manufacturing method comprises the steps of claim 10.

In another aspect not forming part of the present invention a manufacturing apparatus for manufacturing a light emitting device as defined in claim 1 is presented, wherein the manufacturing apparatus comprises:

- a first electrode providing unit and a second electrode providing unit for providing first and second electrodes,
- an organic light emitting diode providing unit for providing an organic light emitting diode, and
- a charge generation unit providing unit for providing a charge generation unit, which comprises an absorbing layer having an absorption shifting the light emitted by the light emitting device towards a longer wavelength within the red part of the spectrum,wherein the first electrode providing unit, the second electrode providing unit, the organic light emitting diode providing unit and the charge generation unit providing unit are adapted such that the first electrode, the organic light emitting diode, the charge generation unit and the second electrode are arranged in a stack, wherein the organic light emitting diode and the charge generation unit are arranged in between the first electrode and the second electrode.

In a further aspect not forming part of the present invention a computer program for controlling a manufacturing apparatus is presented, wherein the computer program comprises program code means for causing the manufacturing apparatus to carry out the steps of the manufacturing method, when the computer program is run on a computer controlling the manufacturing apparatus.

It shall be understood that the light emitting device of claim 1, the vehicle of claim 9, and the manufacturing method of claim 10 have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

BRIEF DESCRIPTION OF THE DRAWINGS

In the following drawings:

Fig. 1 shows schematically and exemplarily an embodiment of a light emitting device comprising organic light emitting diodes,
Fig. 2 shows schematically and exemplarily a vehicle with a rear light comprising the light emitting device,
Fig. 3 shows schematically and exemplarily an embodiment of a manufacturing apparatus for manufacturing the light emitting device,
Fig. 4 shows a flowchart exemplarily illustrating an embodiment of a manufacturing method for manufacturing the light emitting device,
Fig. 5 schematically and exemplarily shows spectra of light emitting diodes together with the human eye sensitivity,
Fig. 6 illustrates schematically and exemplarily a change of a wavelength of an absorption peak depending on a size of nanoparticles, and
Fig. 7 shows schematically and exemplarily an embodiment of a light emitting device comprising an organic light emitting diode.

DETAILED DESCRIPTION OF EMBODIMENTS

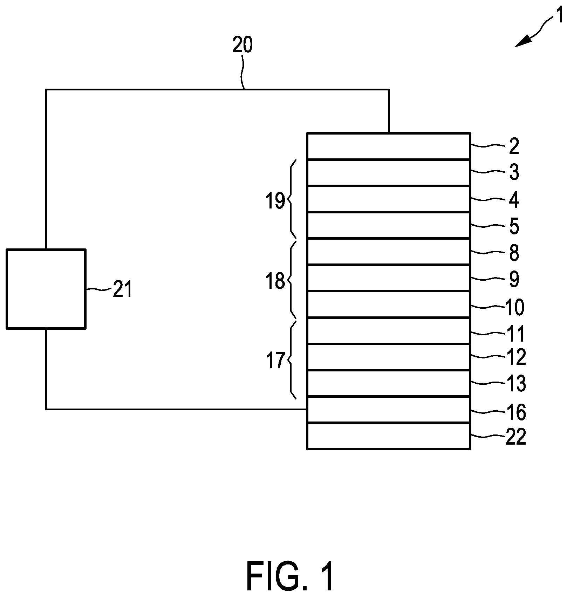

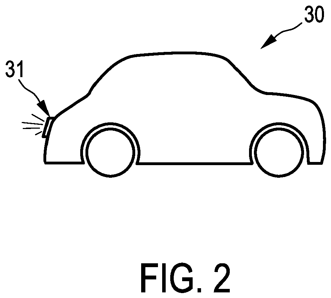

Fig. 1 shows schematically and exemplarily an embodiment of a light emitting device for emitting light. The light emitting device 1 is integrated in a rear light 31 of a vehicle 30 schematically and exemplarily shown in Fig. 2.

The light emitting device 1 comprises a first organic light emitting diode 17 on an anode 16, which is arranged on a substrate 22, a charge generation unit 18 and a second organic light emitting diode 19. On top of the second light emitting diode 19 a cathode 2 is arranged. The anode 16 and the cathode 2 are connected to a voltage source 21 via electrical connections 20.

The first organic light emitting diode 17 comprises a hole transport layer 13, an organic light emitting layer 12 and an electrode transport layer 11. Correspondingly, the second organic light emitting diode 19 comprises a hole transport layer 5, an organic light emitting layer 4 and an electrode transport layer 3.

The organic light emitting layers can comprise a light emitting material or a mixture of different light emitting materials in one organic layer or in several organic sublayers. For instance, fluorescent or phosphorescent light emitting materials like Pt(II) octaethylporphine (PtOEP) or Bis(2-methyldibenzo[*f,h*]quinoxaline) (acetylacetonate)iridium (III) (Ir(mdq)2(acac)) may be doped into hole and/or electron conducting host materials having a triplet energy like Tris(4-carbazoyl-9-ylphenyl)amine (TCTA), 4,4'-Bis(*N*-carbazol-9-yl)-1,1'-biphenyl (CBP) or 2,2',2"-(1,3,5-benzinetriyl)-tris(1-phenyl-1-Hbenzimidazole (TPBi).

The hole transport layers preferentially have a relatively high hole conductivity and a relatively low ionization potential in comparison to, for instance, a hole conducting host material which may be used in the organic light emitting layers, in order to allow for an easy hole injection from the anode. The hole transport layers comprise, for instance, *N,N'*-bis(naphthalen-1-yl)-*N,N'*-bis(phenyl)-2,2'-dimethylbenzidine ($\alpha$-NPD) or Di-[4-(*N,N*-ditolyl-amino)-phenyl]cyclohexane (TAPC).

The electron transport layers preferentially have a relatively high electron conductivity and a relatively large electron affinity, in order to allow electrons to be easily injected from the cathode. The electron transport layers may comprise, for instance, 4,7-diphenyl-1,10-phenanthroline (BPhen) or Tris(8-hydroxy-quinolinato)aluminum (Alq3).

The charge generation unit 18 comprises an n-doped layer 10, a p-doped layer 8 and an intermediate diffusion barrier layer 9. In this embodiment the diffusion barrier layer 9 is a pentacene layer having an absorption shifting the light emitted by the light emitting device 1 towards a longer wavelength within the red part of the spectrum. Thus, in this embodiment the diffusion barrier layer 9 is also an absorbing layer shifting the light emitted by the light emitting device 1 towards a longer wavelength within the red part of the spectrum.

The n-doped layer 10 and the p-doped layer 8 are preferentially doped in their respective bulk, i.e. the doping can be a bulk doping. However, in another embodiment the doping can also be a doping achieved by a layer of dopants arranged adjacent to the layer to be doped. The n-doped layer 10 might be, for instance, a TPBi:Li layer. The p-doped layer 8 might be a $\alpha$-NPD: 2,3,5,6-tetrafluoro-7,7,8,8-tetracyano-quinodimethane ($F_4$-TCNQ) layer or a NPD:$MoO_x$ layer.

The charge generation unit 18 is a unit which usable to stack two or more organic light emitting diodes vertically in series. The charge generation unit is preferentially adapted to separate charge carriers followed by a recombination in the adjacent organic light emission layers. Depending on the layer architecture, the charge generation unit may utilize different mechanisms to separate charge carriers like splitting in an intense intrinsic electric field, tunneling of charges, et cetera. In literature, a charge generation unit may also be referred to as charge generation layer. However, in general, a charge generation unit comprises a layer stack which is used for the charge generation.

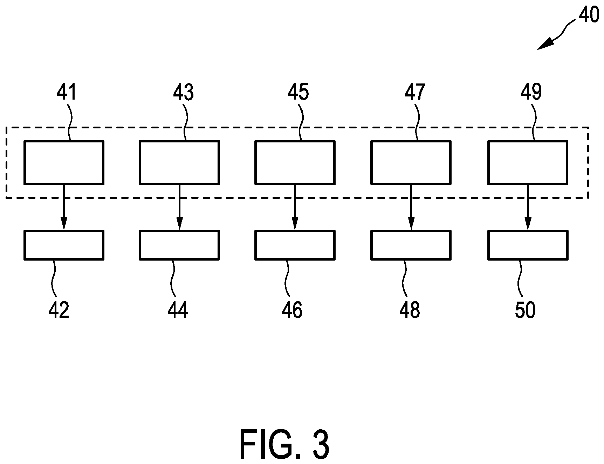

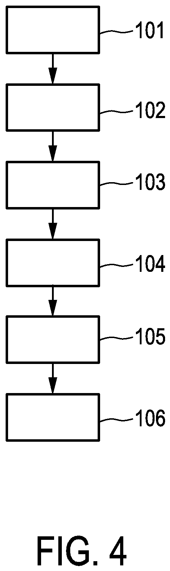

In the following embodiments of a manufacturing apparatus and of a manufacturing method for manufacturing the light emitting device will exemplarily be described with reference to Figs. 3 and 4.

The manufacturing apparatus 40 comprises a first electrode providing unit 41 for providing a first electrode 16 in step 101. In particular, the first electrode providing unit 41 can be adapted to provide a substrate 22 with an anode layer 16 forming the first electrode. In Fig. 3 the substrate with the anode layer is denoted by reference number 42. The manufacturing apparatus 40 further comprises a first organic light emitting diode providing unit 43 for providing a first organic light emitting diode in step 102. In particular, the first organic light emitting diode providing unit 43 is adapted to apply the different layers of the first organic light emitting diode 17 onto the anode layer 16. Thus, the first organic light emitting diode providing unit 43 can be adapted to apply an electron transport layer, an organic light emitting layer and a hole transport layer on the substrate with the anode layer. In Fig. 3 the resulting substrate with the anode and the first organic light emitting diode is denoted by reference number 44.

The manufacturing apparatus 40 further comprises a charge generation unit providing unit 45, which in step 103 provides the charge generation unit with the absorbing layer on the first organic light emitting diode. In particular, the charge generation unit providing unit 45 is adapted to apply the n-doped layer, the diffusion barrier layer and the p-doped layer in this order on the first organic light emitting diode. The resulting intermediate product with the substrate, the anode, the first organic light emitting diode and the charge generation unit is denoted by reference number 46 in Fig. 3.

The manufacturing apparatus 40 further comprises a second organic light emitting diode providing unit 47 for providing a second organic light emitting diode on the charge generation unit. In particular, in step 104 the second organic light emitting diode providing unit 47 applies a hole transport layer, an organic light emission layer and an electrode transport layer on the charge generation unit in this order. The resulting product is denoted by reference number 48 in Fig. 3. Moreover, in step 105 a cathode layer is provided on the electron transport layer of the second organic light emitting diode by using a second electrode providing unit 49. The resulting intermediate product is denoted in Fig. 3 by reference number 50. In step 106 the anode and the cathode may be electrically connected to a voltage source, in order to apply voltage to the first and second organic light emitting diodes.

Although Fig. 3 shows five different units of the manufacturing apparatus 40, the manufacturing apparatus 40 may of course comprise more or less units which generate the different layers. For instance, the first organic light emitting diode providing unit 41 and the second organic light emitting diode providing unit 45 can be integrated in a single light emitting diode providing unit.

Although in the embodiment described above with reference to Fig. 1 the light emitting device comprises a certain sequence of layers, in other embodiments the light emitting device can comprise another sequence of layers which form at least a stack including a first electrode, an organic light emitting diode, a charge generation unit and a second electrode, wherein the organic light emitting diode and the charge generation unit are arranged in between the first and second electrodes and wherein the charge generation unit comprises an absorbing layer having an absorption shifting the light emitted by the light emitting device towards a longer wavelength within the red part of the spectrum. For instance, the first organic light emitting diode and/or the second organic light emitting diode can comprise additional hole injection and/or electron injection layers. For example, between the cathode and the electron transport layer of the second organic light emitting diode 19 an electrode injection layer can be arranged and between the hole transport layer 13 of the first organic light emitting diode 17 and the anode 16 a hole injection layer can be arranged. Moreover, preferentially at least one of the anode 16 and the cathode 2 is at least partly transparent for the light generated by the light emitting device, in order to allow the light to leave the light emitting device.

An emission range, which may be legally allowed for rear lights of a vehicle, at least according to regulations of the Economic Commission for Europe (ECE), ranges from wavelengths of about 610 nm towards the long-wavelength end of the visible spectrum. This is a drawback for known light emitting devices comprising an organic light emitting diode in comparison to, for instance, light emitting devices comprising a non-organic light emitting diode, because the emission spectrum of an organic light emitting diode is generally relatively broad. As the human eye sensitivity is considerably higher for the shorter-wavelength part of the visible spectrum than for the deep red tail of the visible spectrum, the "effective" emission color of a known light emitting device comprising an organic light emitting diode is at a considerably shorter wavelength than the peak of the respective spectrum of the organic light emitting diode. For example, a peak of a spectrum of an organic light emitting diode within a range of 640 to 650 nm may correspond to an effective emission wavelength of the light emitting device comprising the organic light emitting diode of 620 nm. This is in contrast to light emitting devices comprising non-organic light emitting diodes, because in these light emitting devices the real peak wavelength of the spectrum and the effective peak wavelength of the spectrum substantially coincide. Thus, if a light emitting device having a non-organic light emitting diode and a known light emitting device comprising an organic light emitting diode should have the same effective peak wavelength, the spectrum of the light emitted by the organic light emitting diode needs to extend far deeper into the long-wavelength range, where the eye sensitivity and thus the efficacy is very limited, than the spectrum of the non-organic light emitting diode.

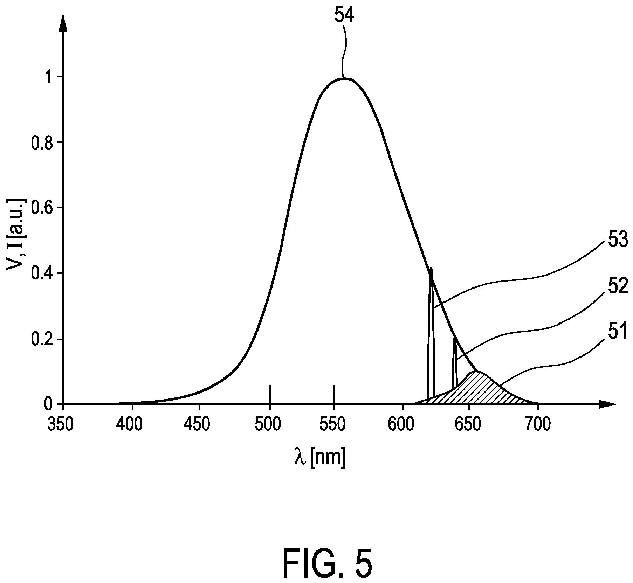

Fig. 5 schematically and exemplarily illustrates the sensitivity V of the human eyes and intensities I of organic and non-organic light emitting diodes in arbitrary units depending on the wavelength $\lambda$ in nm. As can be seen in Fig. 5, spectra 52, 53 of non-organic light emitting diodes are relatively narrow, whereas a spectrum 51 of an organic light emitting diode is relatively broad. In an embodiment the light emitting device described above with reference to Fig. 1 might emit light having such a spectrum 51, if the absorbing layer would not be present. Because of the spectrum 54 of the human eye sensitivity the shorter-wavelength part of the spectrum 51 between, for instance, 620 nm and 650 nm is seen by a human eye more pronounced than the deep red tail of the spectrum 51, which leads to the above described effective emission color peak at, for instance, about 620 nm.

In order to provide a high-performance light emitting device with an organic light emitting diode, i.e., for instance, with a high internal quantum efficiency and device lifetime, in the red wavelength range, absorbing materials with a dedicated absorption spectrum are introduced into the charge generation unit of the light emitting device, thereby tuning the final color point of the light emitted by the light emitting device to the desired wavelength. The absorbing materials are preferentially adapted such that they have an absorption shifting the spectral centroid of the emission of the light emitting device towards a longer wavelength within the red part of the visible spectrum. The spectral centroid c is preferentially defined as the weighted mean of the emission spectrum, wherein the weights correspond to the intensity values at the respective wavelengths. A preferred spectral centroid may be defined by following equation:

$$ c = \frac{\sum \lambda I(\lambda)}{\sum I(\lambda)} \quad , \qquad (1) $$

wherein $I(\lambda)$ denotes the intensity of the light emission at the wavelength X .

Although in the embodiment described above with reference to Fig. 1 the absorbing layer comprises pentacene, in other embodiments another organic, inorganic and/or metal organic absorbing material can be used within the charge generation unit. For instance, a rubrene interlayer may be used within the charge generation unit, wherein the rubrene interlayer may have a thickness of, for instance, 5 nm or 10 nm. It may reach an absorption of 10 to 40 percent at an absorption peak of 527 nm. Moreover, chlorophyll b and/or the polymer P3HT and/or laser dyes and/or metal organic complexes may be used as absorbing materials within the charge generation unit.

Organic chemistry offers an essentially unlimited supply of absorbing molecules of all colors originating from various molecular based structures so that examples can easily be found whose absorption spectrum shifts the light emitted by the light emitting device towards a longer wavelength within the red part of the spectrum. For instance, rubrene may be suitably modified by, for example, attaching and/or detaching side groups. Also other absorbing molecules can easily be found, which, for instance, comprise an absorption spectrum being slightly more green-shifted than the absorption spectrum of pentacene. The selected molecules preferentially absorb the part of the spectrum of deep red emitting organic light emitting diodes, which are more towards the green spectrum, in order to tune the color such that it is within the desired red wavelength range. A generally possible absorption occurring at even shorter wavelengths, for instance, at blue to green wavelengths, which is highly detrimental for white organic light emitting diodes, does not affect the efficacy of the deep red emitting light emitting device described above with reference to Fig. 1. Moreover, since the amount of absorption can be limited to the maximum amount necessary for tuning the color point, an effect of the absorption in, for instance, the red part of the spectrum on the efficacy can at the same time be kept as low as possible.

The absorbing materials, which are added to the charge generation unit, are preferentially selected such that a reemission of these absorbing materials in the visible range is avoided. Thus, the absorbing materials are preferentially chosen such that they do not have a reemission or, due to a wavelength difference between absorption and re-emission, have a reemission in the very deep red to infrared wavelength range only such that the reemission will not affect the color point of the light emission device comprising the organic light emitting diodes.

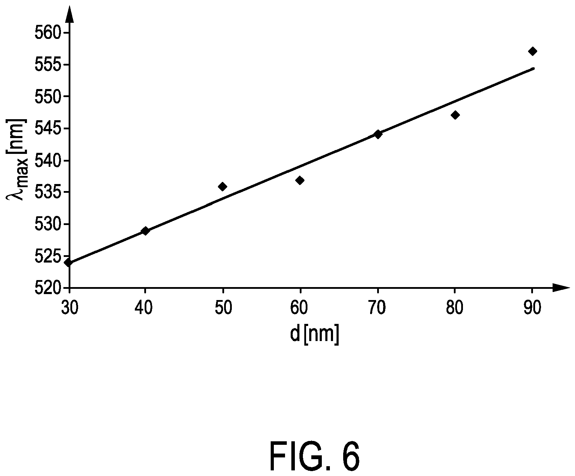

Although in above described embodiments organic absorbing molecules are used as absorbing material for generating an absorbing layer within the charge generation unit which shifts the light emitted by the light emitting device towards a longer wavelength within the red part of the spectrum, in other embodiments also non-organic absorbing materials like copper or gold nanoparticles may be used for generating an absorbing layer within the charge generation unit, which shifts the light emitted by the light emitting device towards a longer wavelength within the red part of the spectrum. In particular, as schematically and exemplarily illustrated in Fig. 6, the wavelength $\lambda_{\text{max}}$ of the absorption peak can be varied by varying the size $d$ of the nanoparticles. Thus, by selecting an appropriate non-organic material and an appropriate nanoparticle size a desired absorption can be generated, which shifts the light emitted by the light emitting device towards a longer wavelength within the red part of the spectrum.

Although in an above described embodiment the absorbing layer is the diffusion barrier layer, in other embodiments the absorbing materials may also form an additional layer in addition to other layers of the charge generation unit, for instance, in addition to an n-doped layer, a diffusion barrier layer and a p-doped layer of the charge generation unit. However, the absorbing materials can also be included in an n-doped layer and/or a p-doped layer of the charge generation unit or in another layer of the charge generation unit.

In addition to introducing the absorbing material into the charge generation unit, the absorbing material may also be introduced into other parts of the light emitting device. For instance, if the anode on the substrate is transparent and the cathode is reflective, an additional absorbing layer may be arranged between the substrate and a light emission layer of the light emitting device or between the cathode and a light emission layer of the light emitting device. Moreover, if the absorbing material does not cause severe trapping, i.e. has a suitable highest occupied molecular orbital (HOMO) level, the absorbing material may be introduced into a hole-transport layer of the light emitting device, wherein the suitable HOMO level may be an energy level within an energy range of, for instance, 4.5 to 6.5 eV.

If in an embodiment the light emitting device also comprises an electron transport layer with a suitable lowest unoccupied molecular orbital (LUMO) level, the absorbing material may be doped into the electron transporting layer, which may be placed directly on the anode followed by a charge generation unit, which may not comprise an absorbing layer, wherein the suitable LUMO level may be an energy level within an energy range of, for instance, 1.5 to 3.5 eV. Thus, in an example between organic light emitting diodes of a light emitting device a charge generation unit with an absorbing layer for shifting the light emitted by the light emitting device towards a longer wavelength within the red part of the spectrum may be present, wherein between the anode and the organic light emitting diode being closest to the anode an electron transporting layer with absorbing material and a further charge generation unit, which may not comprise an absorbing layer, may be arranged.

In a further embodiment additional absorbing layers may also be combined with the substrate, i.e., for instance, on one side of the substrate or on both sides of the substrate, especially between the substrate and the anode, an additional absorbing layer may be present, which shifts the light emitted by the light emitting device towards a longer wavelength within the red part of the spectrum.

The light emitting device is preferentially adapted to be used in automotive rear light applications, wherein the drawback of known light emitting devices having organic light emitting diodes, which generally have a broad spectrum, is used to advantage by using an absorbing layer within the charge generation unit, which shifts the light emitted by the light emitting device towards a longer wavelength within the red part of the spectrum. By using such an absorbing layer within the charge generation unit many emitter materials including those with a slightly too greenish color can be used for automotive purposes.

The light emitting device described above with reference to Fig. 1 is preferentially adapted to allow for a, in view of legal requirements for automotive rear lights, correct emission color within the red wavelength range, a relatively long lifetime even at high operation temperatures and a high brightness. The light emitting device comprises a stacked organic light emitting diode architecture using a charge generation unit, wherein the charge generation unit is preferentially stable under high current and high temperature operation conditions. The charge generation unit comprises a diffusion barrier preferentially made of densely-packed molecules such as pentacene molecules. Pentacene molecules are preferred for automotive applications, because they provide a good diffusion barrier and have an absorption at shorter wavelengths within the visible wavelength spectrum, which has the desired effect to shift the emission spectrum towards deep red.

Although in an above described embodiment the light emitting device comprises two organic light emitting diodes with an intermediate charge generation unit only, in other embodiments the light emitting device can comprise more than two organic light emitting diodes, wherein preferentially between adjacent organic light emitting diodes a charge generation unit is arranged. Thus, if, for example, the light emitting device comprises five organic light emitting diodes, between a first organic light emitting diode and a second organic light emitting diode a first charge generation unit may be arranged, between the second organic light emitting diode and a third organic light emitting diode a second charge generation unit may be arranged, between the third organic light emitting diode and a fourth organic light emitting diode a third charge generation unit may be arranged, and between the fourth organic light emitting diode and a fifth organic light emitting diode a fourth charge generation unit may be arranged. A further charge generation unit may be arranged between a) the first or the last of the organic light emitting diodes and b) an adjacent electrode. At least one of these charge generation units comprises an absorbing layer with an absorption shifting the light emitted by the light emitting device towards a longer wavelength within the red part of the spectrum.

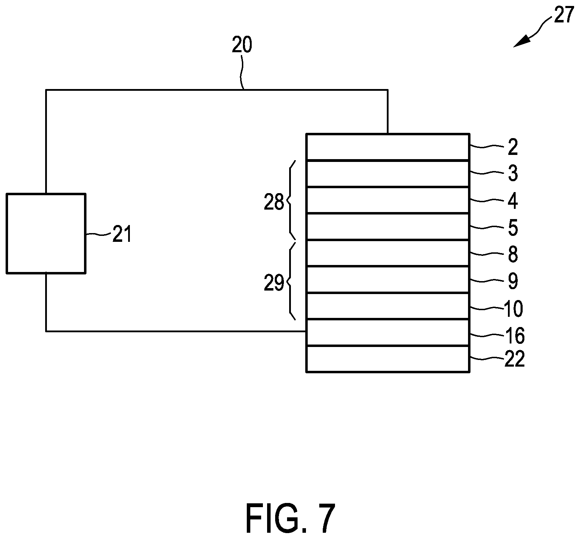

Although in the embodiment described above with reference to Fig. 1 the light emitting device comprises two organic light emitting diodes with an intermediate charge generation unit, in another embodiment the light emitting device can comprise a single organic light emitting diode and a charge generation unit arranged between one of the electrodes and the single organic light emitting diode. Such an embodiment will in the following be described with reference to Fig. 7.

The light emitting device 27 comprises a charge generation unit 29 on an anode 16, which is arranged on a substrate 22, and a single organic light emitting diode 28 on the charge generation unit 29 such that the charge generation unit 29 is arranged between the organic light emitting diode 28 and the anode 16. On top of the organic light emitting diode 28 a cathode 2 is arranged. The anode 16 and the cathode 2 are connected to a voltage source 21 via electrical connections 20.

The organic light emitting diode 28 comprises an electron transport layer 3, an organic light emitting layer 4 and a hole transport layer 5. The charge generation unit 29 comprises an n-doped layer 10, a p-doped layer 8 and an intermediate diffusion barrier layer 9, wherein the n-doped layer 10 and/or the p-doped layer 8 and/or the intermediate diffusion barrier layer 9 comprise an absorbing material having an absorption shifting the light emitted by the light emitting device 27 towards a longer wavelength within the red part of the spectrum.

Although the above described embodiments have a certain polarity, in other embodiments the polarity can be different, i.e. other embodiments can have an inverse polarity. Moreover, although in an above described embodiment the diffusion barrier layer is also the absorbing layer, in another embodiment the diffusion barrier layer and the absorbing layer can be different layers. In particular, besides the n-doped layer, the p-doped layer and the diffusion barrier layer the charge generation unit can comprise a further layer being the absorbing layer. This additional absorbing layer may be arranged in between the p-doped layer and the n-doped layer adjacent to the diffusion barrier layer. Thus, the diffusion functionality and the absorbing functionality can be provided in a two-layer system.

In an embodiment the diffusion barrier layer of the charge generation unit is adapted such that it hinders the diffusion of dopants of other layers of the light emitting device. The diffusion barrier layer may comprise, for instance, flat molecules forming a crystalline structure like a herringbone structure or spherical molecules that are densely packed especially similar to the packing in a hexagonal/cubic closely packed arrangement.

In the claims, the word "comprising" does not exclude other elements or steps, and the indefinite article "a" or "an" does not exclude a plurality.

A single unit or device may fulfill the functions of several items recited in the claims. The mere fact that certain measures are recited in mutually different dependent claims does not indicate that a combination of these measures cannot be used to advantage.

The control of the manufacturing apparatus in accordance with the manufacturing method can be implemented as program code means of a computer program and/or as dedicated hardware.

A computer program may be stored/distributed on a suitable medium, such as an optical storage medium or a solid-state medium, supplied together with or as part of other hardware, but may also be distributed in other forms, such as via the Internet or other wired or wireless telecommunication systems.

Any reference signs in the claims should not be construed as limiting the scope.

## Claims

1. A rear red light (31) of a vehicle (30) comprising a red light emitting device for emitting light with an emission range of 610nm towards a long-wavelength end of the visible spectrum suitable for automotive rear lighting, wherein the red light emitting device (1; 27) comprises a stack including a first electrode (16), an organic light emitting diode (17; 28) emitting in a red wavelength range, a charge generation unit (18; 29) and a second electrode (2), wherein the organic light emitting diode (17; 28) and the charge generation unit (18; 29) are arranged in between the first and second electrodes (16, 2), wherein
the charge generation unit (18; 29) comprises in order, a p-doped layer (8), an absorbing layer (9) having an absorption shifting the red light emitted by the light emitting device (1; 27) towards a longer wavelength within the red part of the visible spectrum, and an n-doped layer (10).

2. The rear light (31) as defined in claim 1, wherein the stack includes a further organic light emitting diode (19), wherein the charge generation unit (18) is arranged between the organic light emitting diodes (17, 19).

3. The rear light (31) as defined in claim 1, wherein the absorbing layer comprises an organic material with adapted molecular based structures providing the desired absorption and/or an inorganic material comprising nanoparticles with an adapted size in order to provide the desired absorption, and/or a metal organic material.

4. The rear light (31) as defined in claim 3, wherein the organic material is a material selected from a group consisting of pentacene derivatives and rubrene derivatives, which are modified by attaching and/or detaching side groups to pentacene or rubrene in order to provide the desired absorption.

5. The rear light (31) as defined in claim 3, wherein the inorganic material comprises copper and/or gold nanoparticles.

**6.** The rear light (31) as defined in claim 1, wherein the absorption material has no reemission in the visible spectrum or has a reemission only in a very deep red to infrared wavelength range.

**7.** The rear light (31) as defined in claim 1, wherein the charge generation unit (29) is arranged between one of the electrodes (2, 16) and the organic light emitting diode (28).

**8.** The rear light (31) as defined in claim 1, wherein the absorbing layer (9) is configured to absorb part of the green spectrum of the red emission of the organic light emitting diode (17; 28).

**9.** A vehicle (30) comprising the rear light (31) as defined in any of the preceding claims.

**10.** A manufacturing method for manufacturing the rear red light (31) as defined in claim 1 with an emission range of 610nm towards a long-wavelength end of the visible spectrum suitable for automotive rear lighting, wherein the manufacturing method comprises:

providing first and second electrodes (16, 2),
providing an organic light emitting diode (17; 28) emitting in a red wavelength range, and
providing a charge generation unit (18; 29), which comprises in order, a p-doped layer (8), an absorbing layer (9) having an absorption shifting the light emitted by the light emitting device (1; 28) towards a longer wavelength within the red part of the visible spectrum, and an n-doped layer (10),
wherein the first and second electrodes (16, 2), the organic light emitting diode (17; 28) and the charge generation unit (18; 29) are provided such that the first electrode (16), the organic light emitting diode (17; 28), the charge generation unit (18; 29) and the second electrode (2) are arranged in a stack, wherein the organic light emitting diode (17; 28) and the charge generation unit (18; 29) are arranged in between the first electrode (16) and the second electrode (2).

**Patentansprüche**

**1.** Rotes Rücklicht (31) eines Fahrzeugs (30) mit einer Rotlicht-Emissionsvorrichtung zum Emittieren von Licht mit einem Emissionsbereich von 610 nm in Richtung eines langwelligen Endes des sichtbaren Spektrums, das für eine Kraftfahrzeug-Heckbeleuchtung geeignet ist, wobei die Rotlicht-Emissionsvorrichtung (1; 27) einen Stapel umfasst, der eine erste Elektrode (16), eine organische Leuchtdiode (17; 28), die in einem roten Wellenlängenbereich emittiert, eine Ladungserzeugungseinheit (18; 29) und eine zweite Elektrode (2) umfasst, wobei die organische Leuchtdiode (17; 28) und die Ladungserzeugungseinheit (18; 29) zwischen der ersten und der zweiten Elektrode (16, 2) angeordnet sind, wobei die Ladungserzeugungseinheit (18; 29) der Reihe nach eine p-dotierte Schicht (8), eine absorbierende Schicht (9) mit einer Absorption, die das von der Licht-Emissionsvorrichtung (1; 27) emittierte rote Licht zu einer längeren Wellenlänge innerhalb des roten Teils des sichtbaren Spektrums verschiebt, und eine n-dotierte Schicht (10) umfasst.

**2.** Rücklicht (31) nach Anspruch 1, wobei der Stapel eine weitere organische Leuchtdiode (19) enthält, wobei die Ladungserzeugungseinheit (18) zwischen den organischen Leuchtdioden (17, 19) angeordnet ist.

**3.** Rücklicht (31) nach Anspruch 1, wobei die absorbierende Schicht ein organisches Material mit angepassten Strukturen auf Molekularbasis, die die gewünschte Absorption bereitstellen, und/oder ein anorganisches Material, das Nanopartikel mit einer angepassten Größe umfasst, um die gewünschte Absorption bereitzustellen, und/oder ein metallorganisches Material umfasst.

**4.** Rücklicht (31) nach Anspruch 3, wobei das organische Material ein Material ist, das aus einer Gruppe ausgewählt ist, die aus Pentacenderivaten und Rubrenderivaten besteht, die durch Anbringen und/oder Ablösen von Seitengruppen an Pentacen oder Rubren modifiziert sind, um die gewünschte Absorption zu erzielen.

**5.** Rücklicht (31) nach Anspruch 3, wobei das anorganische Material Kupfer- und/oder Goldnanopartikel umfasst.

**6.** Rücklicht (31) nach Anspruch 1, wobei das Absorptionsmaterial keine Wiederemission im sichtbaren Spektrum oder eine Wiederemission nur in einem sehr tiefen roten bis infraroten Wellenlängenbereich aufweist.

**7.** Rücklicht (31) nach Anspruch 1, wobei die Ladungserzeugungseinheit (29) zwischen einer der Elektroden (2, 16) und der organischen Leuchtdiode (28) angeordnet ist.

8. Rücklicht (31) nach Anspruch 1, wobei die absorbierende Schicht (9) so konfiguriert ist, dass sie einen Teil des grünen Spektrums der roten Emission der organischen Leuchtdiode (17; 28) absorbiert.

9. Fahrzeug (30) mit dem Rücklicht (31), wie in einem der vorhergehenden Ansprüche definiert.

10. Herstellungsverfahren zur Herstellung des roten Rücklichts (31) nach Anspruch 1 mit einem Emissionsbereich von 610 nm in Richtung eines langwelligen Endes des sichtbaren Spektrums, das für Kraftfahrzeugrückbeleuchtung geeignet ist, wobei das Herstellungsverfahren umfasst:

Bereitstellung von ersten und zweiten Elektroden (16, 2),
Bereitstellung einer organischen Leuchtdiode (17; 28), die in einem roten Wellenlängenbereich emittiert, und
Bereitstellen einer Ladungserzeugungseinheit (18; 29), die der Reihe nach eine p-dotierte Schicht (8), eine absorbierende Schicht (9) mit einer Absorption, die das von der Licht-Emissionsvorrichtung (1; 28) emittierte Licht zu einer längeren Wellenlänge innerhalb des roten Teils des sichtbaren Spektrums verschiebt, und eine n-dotierte Schicht (10) umfasst,
wobei die erste und zweite Elektrode (16, 2), die organische Leuchtdiode (17; 28) und die Ladungserzeugungseinheit (18; 29) so vorgesehen sind, dass die erste Elektrode (16), die organische Leuchtdiode (17; 28), die Ladungserzeugungseinheit (18; 29) und die zweite Elektrode (2) in einem Stapel angeordnet sind, wobei die organische Leuchtdiode (17; 28) und die Ladungserzeugungseinheit (18; 29) zwischen der ersten Elektrode (16) und der zweiten Elektrode (2) angeordnet sind.

**Revendications**

1. Feu rouge arrière (31) d'un véhicule comprenant un dispositif électroluminescent rouge pour émettre de la lumière dans une plage d'émission de 610 nm en direction d'une extrémité de longueur d'onde longue du spectre visible approprié à l'éclairage arrière automobile, le dispositif électroluminescent rouge (1, 27) comprenant un empilement comprenant une première électrode (16), une diode électroluminescente organique (17, 28) émettant dans une gamme de longueurs d'onde rouge, une unité de génération de charge (18, 29) et une seconde électrode (2), la diode électroluminescente organique (17, 28) et l'unité de génération de charge (18, 29) étant disposées entre la première et la seconde électrode (16, 2),
l'unité de production de charge (18, 29) comprenant dans l'ordre, une couche dopée p (8), une couche d'absorption (9) ayant une absorption décalant la lumière rouge émise par le dispositif électroluminescent (1, 27) en direction d'une longueur d'onde plus longue dans la partie rouge du spectre visible, et une couche dopée n (10).

2. Feu rouge arrière (31) selon la revendication 1, l'empilement comprenant une autre diode électroluminescente organique (19), l'unité de génération de charge (18) étant disposée entre les diodes électroluminescentes organiques (17, 19).

3. Feu rouge arrière (31) selon la revendication 1, la couche d'absorption comprenant un matériau organique ayant des structures moléculaires adaptées pour obtenir l'absorption souhaitée et/ou un matériau inorganique comprenant des nanoparticules ayant une taille adaptée afin d'obtenir l'absorption souhaitée, et/ou un matériau organique métallique.

4. Feu rouge arrière (31) selon la revendication 3, le matériau organique étant un matériau sélectionné dans un groupe constitué de dérivés de pentacène et de dérivés de rubrène, qui sont modifiés en leur greffant et/ou en les détachant de groupes latéraux au pentacène ou rubrène afin d'obtenir l'absorption souhaitée.

5. Feu rouge arrière (31) selon la revendication 3, le matériau inorganique comprenant des nanoparticules de cuivre et/ou d'or.

6. Feu rouge arrière (31) selon la revendication 1, le matériau d'absorption ayant aucune réémission dans le spectre visible ou ayant une réémission uniquement dans un rouge très profond de la gamme de longueurs d'onde infrarouge.

7. Feu rouge arrière (31) selon la revendication 1, l'unité de génération de charge (29) étant disposée entre l'une des électrodes (2, 16) et la diode électroluminescente organique (28).

8. Feu rouge arrière (31) selon la revendication 1, la couche d'absorption (9) étant conçue pour absorber une partie du spectre vert de l'émission rouge de la diode électroluminescente organique (17, 28).

9. Feu rouge arrière (31) comprenant la lumière rouge (31) selon l'une quelconque des revendications précédentes.

10. Procédé de fabrication de la lumière rouge selon la revendication 1, ayant une plage d'émission de 610 nm en direction d'une extrémité de longueur d'onde longue du spectre visible approprié pour l'éclairage arrière automobile, le procédé de fabrication consistant à :

fournir une première et une seconde électrode (16, 2),
fournir une diode électroluminescente organique (17, 28) émettant dans une gamme de longueurs d'onde rouge, et
fournir une unité de génération de charge (18, 29) qui comprend dans l'ordre, une couche dopée p (8), une couche d'absorption (9) ayant une absorption décalant la lumière rouge émise par le dispositif électroluminescent (1, 28) en direction d'une longueur d'onde plus longue dans la partie rouge du spectre visible, et une couche dopée n (10),
la première et la seconde électrode (16, 2), la diode électroluminescente organique (17, 28) et l'unité de production de charge (18, 29) sont disposées de sorte à former un empilement avec la première électrode (16), la diode électroluminescente organique (17, 28), l'unité de production de charge (18, 29) et la seconde électrode (2), la diode électroluminescente organique (17, 28) et l'unité de production de charge (18, 29) étant disposées entre la première électrode (16) et la seconde électrode (2).

FIG. 1

FIG. 2

FIG. 3

FIG. 4

FIG. 5

FIG. 6

**FIG. 7**

# EP 2 983 221 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012205685 A1
- US 2010288362 A1
- US 2014061600 A1
- US 2012241726 A1
- WO 2012162203 A2